Europäisches Patentamt

European Patent Office

Office européen des brevets

(19)

(11) **EP 0 357 141 B1**

(12) **EUROPÄISCHE PATENTSCHRIFT**

(45) Veröffentlichungstag und Bekanntmachung des Hinweises auf die Patenterteilung:
**07.02.1996 Patentblatt 1996/06**

(51) Int Cl.[6]: **G01R 33/36**, G01R 33/54

(21) Anmeldenummer: **89202181.7**

(22) Anmeldetag: **29.08.1989**

(54) **Hochfrequenzerzeuger für Kernspinuntersuchungsgeräte**

High-frequency generator for a nuclear spin examining apparatus

Générateur de haute fréquence pour un appareil d'examen à spin nucléaire

(84) Benannte Vertragsstaaten:
**DE FR GB NL**

(30) Priorität: **30.08.1988 DE 3829374**

(43) Veröffentlichungstag der Anmeldung:
**07.03.1990 Patentblatt 1990/10**

(73) Patentinhaber:
- **Philips Patentverwaltung GmbH
  D-22335 Hamburg (DE)**
  Benannte Vertragsstaaten:
  **DE**
- **Philips Electronics N.V.
  NL-5621 BA Eindhoven (NL)**
  Benannte Vertragsstaaten:
  **FR GB NL**

(72) Erfinder:
- **Proksa, Roland
  D-2000 Hamburg 20 (DE)**
- **McKinnon, Graeme, Dr.
  CH-8053 Zürich (CH)**

(74) Vertreter: **Hartmann, Heinrich, Dipl.-Ing. et al
D-22335 Hamburg (DE)**

(56) Entgegenhaltungen:
EP-A- 0 292 064           DE-A- 3 605 162
DE-A- 3 605 547

- **MEDICAL & BIOLOGICAL ENGINEERING & COMPUTING, Band 26, Nr. 2, März 1988, Seiten 221-224, IFMBE, Stevenage, Herts, GB ; PITTARD et al.: "Nuclear magnetic resonance imaging using a microcomputer"**
- **JOURNAL OF SCIENTIFIC INSTRUMENTS (JOURNAL OF PHYSICS E), Band 1, Nr. 6, Series 2, Juni 1968, Seiten 604-606; I.J. LOWE et al.: "A high-power, untuned radio-frequency transmitter for pulsed nuclear magnetic resonance spectroscopy"**
- **PROCEEDINGS OF THE EIGHT ANNUAL CONFERENCE OF THE IEEE/ENGINEERING IN MEDICINE AND BIOLOGY, November 1986, Seiten 1139-1141 ; M. SAUZADE et al.: "Simulation and test of a slice profile for N.M.R. imaging system"**

**Beschreibung**

Hochfrequenzerzeuger für
Kernspinuntersuchungsgeräte

Die Erfindung betrifft einen Hochfrequenzerzeuger nach dem Oberbegriff des Anspruchs 1. Ein solcher Hochfrequenzerzeuger ist aus der DE-OS 36 05 547 bekannt. Dabei erfolgt eine Amplitudenmodulation des Hüllkurvensignals auf den Träger. Die nachgeschaltete Sendestufe dient als linearer Verstärker für den amplitudenmodulierten Träger. Derartige Verstärker müssen eine Ausgangsleistung von einigen hundert W bis zu einigen kW liefern. Die modulierte Trägerfrequenz liegt dabei je nach Stärke des magnetischen Feldes des Kernspinuntersuchungsgerätes, in dem der Hochfrequenzerzeuger benutzt wird, zwischen 5 MHz und ca. 200 MHz. Solche Verstärker sind teuer.

Aufgabe der vorliegenden Erfindung ist es, einen Hochfrequenzerzeuger der eingangs genannten Art so auszugestalten, daß die Sendestufe vereinfacht werden kann.

Diese Aufgabe wird erfindungsgemäß durch die im Anspruch angegebenen Maßnahmen gelöst. Bei der Erfindung wird also nicht die Amplitude des der Sendestufe zugeführten Trägersignals entsprechend dem Hüllkurfensignal variiert, sondern die Dichte und die Phase der Schwingungen mit der Trägerfrequenz. Jede Schwingung steuert die Sendestufe voll durch, so daß diese im Schaltbetrieb arbeitet, wodurch einerseits die Anforderungen an die Linearität der Sendestufe herabgesetzt werden und andererseits die in der Sendestufe in Wärme umgesetzte Verlustleistung verringert wird. Eine solche Sendestufe mit geringen Anforderungen an die Linearität und geringer Verlustleistung läßt sich mit relativ einfachen Mitteln aufbauen.

Die Leistung wird dabei dadurch verändert, daß der zeitliche Abstand zwischen den einzelnen Trägerschwingungen verändert wird.

Es sei an dieser Stelle erwähnt, daß aus einer Veröffentlichung von M. Sauzade et al, Proceedings of the Eighth Annual Conference of the IEEE/Engineering in Medicine and Biology Society, 1986, Seiten 1139-1141, ein MR-Verfahren bekannt ist, bei dem eine Folge von pulsbreitenmodulierten Impulsen in Verbindung mit einem Klasse C Verstärker verwendet wird. Demgegenüber betrifft die Erfindung eine Pulsdichtemodulation, und sie erlaubt die Verwendung eines Klasse D Verstärkers. Diese Klasse besitzt Vorteile gegenüber Klasse C Verstärkern.

Die Phase der von der Sendestufe verarbeiteten Trägerschwingung wird durch den Digitalwert des Impulses bestimmt. Wenn der Impuls nur zwei verschiedene Digitalwerte annehmen kann, nämlich entweder einen positiven oder einen negativen, ist die Polarität jedes Impulses durch die Polarität des Hüllkurvensignals zu dem betreffenden Zeitpunkt bestimmt, wobei während Impulsen mit der einen Polarität die Trägerschwingung mit einer ersten Phasenlage und bei Impulsen mit der entgegengesetzten Polarität die Trägerschwingung mit der entgegengesetzten Phasenlage der Sendestufe zugeführt wird. Grundsätzlich wäre es auch möglich, den Impulsen mehr als zwei verschiedene Digitalwerte zuzuordnen, beispielsweise vier. Dies könnte etwa dann von Nutzen sein, wenn das Hüllkurvensignal komplex, d.h. mit Real- und Imaginärteil vorgegeben wäre. Der Aufwand für den Modulator ist dabei aber wesentlich größer.

Im allgemeinen können die Impulse asynchron in bezug auf die Trägerschwingung auftreten. Die Realisierung eines auf dieser Basis arbeitenden Modulators bereitet aber erhebliche Schwierigkeiten. Ein wesentlich einfacherer Aufbau ergibt sich in weiterer Ausgestaltung der Erfindung dadurch, daß der Träger innerhalb des kürzestmöglichen Abstandes T zwischen zwei Impulsen gerade eine oder mehrere ganze Schwingungen ausführt, und daß der Abstand zwischen zwei aufeinanderfolgenden Impulsen mT ist, wobei m eine positive ganze Zahl ist. Dadurch werden die Impulse stets in derselben zeitlichen Lage in bezug auf die Trägerschwingung ausgeschaltet, vorzugsweise bei deren Nulldurchgang, was die Verarbeitung wesentlich erleichtert. In diesem Fall ist es aber nicht mehr möglich, die Pulsdichte bzw. den zeitlichen Abstand zwischen zwei Impulsen kontinuierlich zu variieren. Dies kann vielmehr nur noch in diskreten Schritten der Größe T geschehen. Um dabei einen genügenden Dynamikumfang zu erreichen, muß der Zeitraum T sehr kurz im Vergleich zur Dauer des Hüllkurvensignals sein, beispielsweise 1/1000 davon oder weniger.

Während bei einer Sendestufe mit einem linear betriebenen Endverstärker innerhalb gewisser Grenzen die Ausgangsleistung des Verstärkers praktisch unabhängig ist von seiner Versorgungsspannung, schwankt bei einem Schaltverstärker die Ausgangsleistung stark mit der Versorgungsspannung. Diese Versorgungsspannungsabhängigkeit könnte durch Verwendung eines stabilisierten Versorgungsspannungserzeugers vermieden werden. Dieser müßte für mehrere hundert W bzw. einige kW ausgelegt sein und wäre dadurch sehr teuer.

Demgegenüber sieht eine Weiterbildung der Erfindung vor, daß die Sendestufe an eine nicht stabilisierte Versorgungsspannung angeschlossen ist, daß ein Analog/Digital-Wandler vorgesehen ist, der ein der Versorgungsspannung proportionales Signal digitalisiert, und daß der erste Modulatorteil einer Akkumulatorschaltung zur Bildung eines von dem Integral der Differenz zwischen den Impulsen und dem Hüllkurvensignal abhängigen Steuersignals vorgesehen ist, und daß das Steuersignal eine Logikschaltung beaufschlagt, die einen Impuls der einen oder der anderen Art erzeugt derart, daß das Integral innerhalb eines bestimmten Bereiches bleibt. Dabei wird also eine nicht stabilisierte Versorgungsspannung in Kauf genommen und die mit der schwankenden Versorgungsspannung einhergehende Schwankung der Ausgangsleistung wird dadurch kompensiert, daß das Hüllkurvensignal umgekehrt proportional zur Versorgungsspannung geändert wird. Die Energie, die in einer einzigen Trägerschwingung steckt, schwankt dabei zwar mit der Versorgungsspannung, doch wird die Ausgangsleistung dadurch konstant gehalten, daß das Hüllkurvensignal - und damit die Impulsdichte - umgekehrt proportional zur Versorgungsspannung geändert wird.

Die Erfindung wird nachstehend anhand der Zeichnung näher erläutert. Es zeigen:

Fig. 1    ein Blockschaltbild eines erfindungsgemäßen Kernspinuntersuchungsgerätes, bei dem die Erfindung anwendbar ist,

Fig. 2    ein Blockschaltbild eines erfindungsgemäßen Hochfrequenzerzeugers,

Fig. 3    den zeitlichen Verlauf des Hüllkurvensignals und des davon pulsdichtemodulierten Signals bei einem Hochfrequenzimpuls, und

Fig. 4    den zeitlichen Verlauf verschiedener Signale innerhalb eines Teils eines solchen Hochfrequenzimpulses.

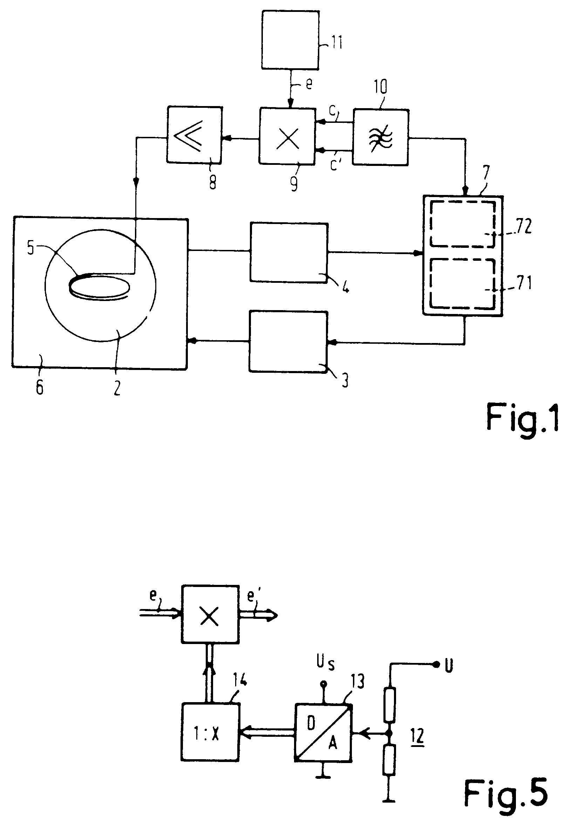

In Fig. 1 ist mit 6 eine Vorrichtung bezeichnet, die einen Magneten enthält, der in einem Untersuchungsbereich 2 ein zur Zeichenebene senkrecht verlaufendes homogenes stationäres Magnetfeld erzeugt. Dessen magnetische Flußdichte kann zwischen wenigen zehntel Tesla und einigen Tesla liegen. Zusätzlich werden bei Bedarf auch magnetische Gradientenfelder erzeugt, d.h. Magnetfelder, die in der gleichen Richtung verlaufen wie das stationäre homogene Magnetfeld, deren Stärke sich jedoch linear in Richtung des Magnetfeldes oder in einer dazu senkrechten Richtung ändert. Die Vorrichtung 6 ist zu diesem Zweck mit einem Generator 3 gekoppelt, der die Ströme für die magnetischen Gradientenfelder liefert. Außerdem ist eine Hochfrequenzspule 5 vorgesehen, die ein zum stationären Magnetfeld senkrechtes, hochfrequentes Magnetfeld erzeugt und die an den Ausgang eines Sendeteils angeschlossen ist. Die Frequenz des hochfrequenten Magnetfeldes entspricht der Larmorfrequenz, die bekanntlich der magnetischen Flußdichte des homogenen stationären Magnetfeldes proportional ist; bei einer Flußdichte von z.B. 0,2 T beträgt sie etwa 8,5 MHz. Das Sendeteil umfaßt einen Verstärker 8, der an den Ausgang eines Modulators 9 angeschlossen ist, in dem ein Träger mit der Larmorfrequenz, der von einem Oszillator 10 in zwei gegeneinander um 180° versetzten Phasenlagen (c bzw. c') erzeugt wird, mit einem Hüllkurvensignal e moduliert wird, das in einem Speicher 11 als Folge von digitalen Datenworten gespeichert ist.

Die im Untersuchungsbereich 2 erzeugten Kernresonanzsignale werden von der Hochfrequenzspule 5 oder einer anderen Hochfrequenzspule aufgenommen und in einem Empfänger 4 in den Niederfrequenzbereich umgesetzt und digitalisiert.

Die Steuerung erfolgt durch eine digitale Zentraleinheit 7, die zu diesem Zweck einen Steuerteil 71 enthält. Außerdem umfaßt die digitale Zentraleinheit einen Verarbeitungsteil 72, der die vom Empfänger 4 gelieferten Daten verarbeitet und daraus die Kernmagnetisierungsverteilung im Untersuchungsbereich 2 rekonstruiert.

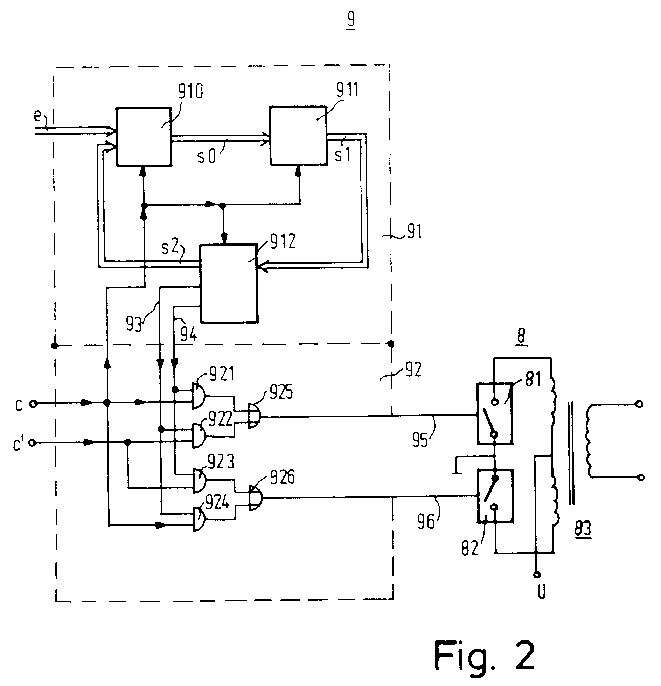

In Fig. 2 ist ein Blockschaltbild des Modulators 9 und des Verstärkers 8, der sogenannten Sendestufe, dargestellt. Der Modulator 9 besteht aus zwei Modulatorteilen 91 und 92. In dem ersten Modulatorteil 91 wird das Hüllkurvensignal e, das aus dem Speicher 11 mit einer Wortbreite von z.B. 16 Bit entnommen wird, in eine Folge p von gleich großen und gleich langen Impulsen einer ersten oder zweiten Art - je nach Polarität des Hüllkurvensignals e - umgesetzt, deren Dichte der Amplitude des digitalen Hüllkurvensignals entspricht, vorzugsweise dazu proportional ist. Dieser erste Teil wird daher im folgenden auch als Pulsdichtemodulator bezeichnet.

Im zweiten Teil 92 des Modulators werden die von dem Oszillator 10 (Fig. 1) gelieferten, zueinander gegenphasigen Trägersignale c, c' durch die pulsdichtemodulierten Signale moduliert. Diese Modulation besteht darin, daß je nach Wert des vom Pulsdichtemodulator erzeugten digitalen Impulses entweder eines der beiden Trägersignale oder keins von beiden zum Gegentaktausgang dieses Modulatorteils durchgeschaltet und dem Eingang der Sendestufe 8 zugeführt wird.

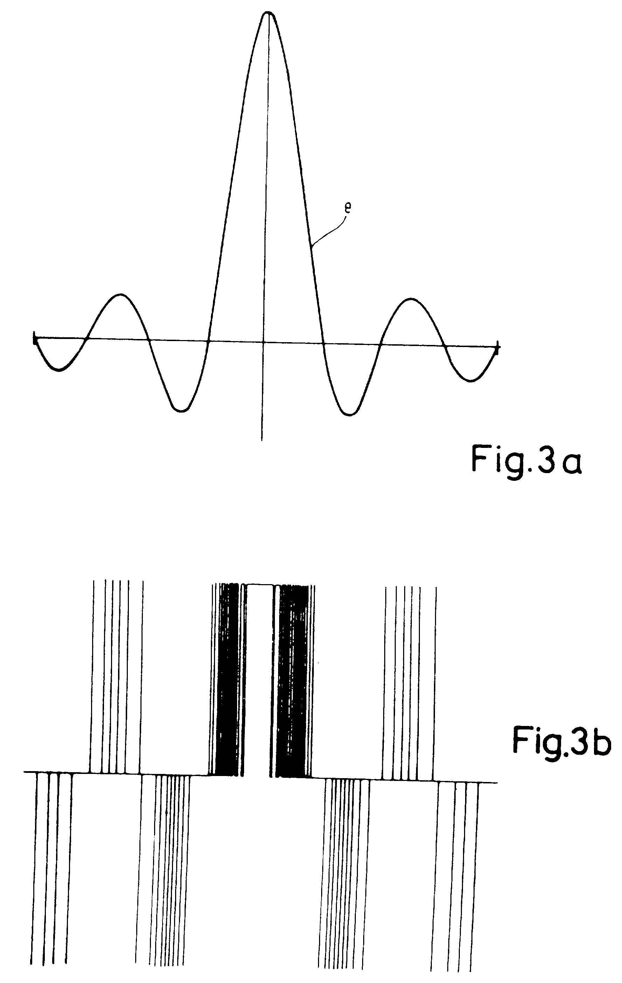

In Fig. 3a ist der Verlauf des Hüllkurvensignals für einen typischen Hochfrequenzimpuls dargestellt, der in einem Kernspinuntersuchungsgerät nach Fig. 1 zur Anregung der Kernmagnetisierung in einer bestimmten Schicht des Untersuchungsbereiches dienen kann. Unter "Hochfrequenzimpuls" wird dabei ein Hochfrequenzsignal verstanden, das viele tausend Perioden der Trägerschwingung umfassen kann, während mit "Impuls" ein Signal bezeichnet wird, das eine oder nur wenige Schwingungen des Trägers umfaßt. Trotz seiner analogen Darstellung handelt es sich hierbei um ein digitales Signal.

Fig. 3b zeigt - in analoger Darstellung - das dazu korrespondierende pulsdichtemodulierte Signal, wobei den Impulsen mit dem einen digitalen Wert eine positive Polarität und den Impulsen mit dem anderen Wert eine negative Polarität zugeordnet ist. Im übrigen haben die Impulse die gleiche Amplitude und die gleiche Dauer. Man erkennt im Mittelteil, daß die Impulsdichte dabei so groß werden kann, daß die Impulse lückenlos aneinander anschließen.

Die Impulsdichtemodulation könnte in der Weise erfolgen, daß aus dem Amplitudenverlauf des Hüllkurvensignals e der zeitliche Verlauf des pulsdichtemodulierten Signals p berechnet würde, d.h. daß jeder Amplitude ein dazu proportionaler Abstand zwischen zwei aufeinanderfolgenden Impulsen zugeordnet wird - ausgedrückt in Vielfachen eines Zeitraums T, der eine oder mehrere ganze Schwingungen des Trägersignals umfassen kann. Die Polarität des Hochfrequenzimpulses p müßte entsprechend der Polarität des Hüllkurvensignals e gewählt werden.. Ein solches Verfahren wäre einerseits relativ ungenau, weil lediglich die Momentanwerte des Hüllkurvensignals berücksichtigt würden, und andererseits nur mit relativ großem Aufwand zu realisieren. Der Ln Fig. 2 dargestellte, genaue und relativ einfache Pulsdichtemodulator 91 basiert auf dem Gedanken, das zeitliche Integral über das Hüllkurvensignal e und über das pulsdichtemodulierte Signal p zu bilden und in Abhängigkeit von der Differenz der Integrale - bzw. des Integrals der Differenz - zu entscheiden, ob ein Impuls erzeugt werden soll (wenn ein bestimmter Wertebereich über- oder unterschritten wird) und welche Polarität der Impuls haben muß, damit das erwähnte Integral über die Differenz möglichst klein wird.

Zu diesem Zweck enthält der Pulsdichtemodulator einen digitalen Addierer 910, dessen Ausgang mit einem Register 911 verbunden ist, dessen Ausgangssignal einer PAL-Logikstufe 912 (PAL = Programable Array Logic) zugeführt wird. Diese Logikstufe kann an einem mit einem Eingang des Addierers 910 verbundenen Ausgang gleich große digitale Impulse unterschiedlicher Polarität erzeugen und liefert an einem anderen Ausgang zeitgleich mit den Impulsen aus diesen abgeleitete Modulatorsignale für den zweiten Modulatorteil 92. Das Hüllkurvensignal e wird einem zweiten Eingang des Addierers 910 zugeführt. Den drei Stufen 910, 911 und 912 wird ein Taktsignal mit der Trägerfrequenz zugeführt. Statt dessen könnte auch ein Taktsignal verwendet werden, dessen Frequenz zweimal, dreimal oder mehrmals niedriger ist als die Frequenz des Trägers, das aber mit dem Träger synchronisiert ist. Je niedriger die Taktfrequenz ist, desto einfacher läßt sich der Pulsdichtemodulator realisieren, desto ungenauer ist aber die Pulsdichtemodulation. Die Wahl der Taktfrequenz ist also ein Kompromiß zwischen Aufwand und Genauigkeit. Bei Kernspinuntersuchungsgeräten mit niedriger magnetischer Flußdichte und dadurch bedingt niedriger Trägerfrequenz wird man die Taktfrequenz wie im Ausführungsbeispiel gleich der Trägerfrequenz wählen.

Bei der nachfolgenden Erläuterung des Pulsdichtemodulators 91 bezeichnen kleine Buchstaben den Momentanwert eines digitalen Signals und große Buchstaben das Integral über ein Signal von dem ersten Takt bis zu einem bestimmten Zeitpunkt. Dieser Zeitpunkt wird durch den Index gekennzeichnet, der dem betreffenden Buchstaben angefügt ist. So bezeichnet beispielsweise $e_n$ den Wert des digitalen Hüllkurvensignals e nach n Takten.

Im folgenden wird der Pulsdichtemodulator nach n+1 Takten betrachtet. Das Ausgangssignal sO des Addierers 910 genügt dann der Gleichung:

$$sO = e_{n+1} + F_n \qquad (1).$$

Für $F_n$ gilt dabei:

$$F_n = E_n - P_n \qquad (2).$$

$F_n$ entspricht also dem Integral über die Differenz zwischen E und P bzw. der Summe dieser Differenzen nach n Takten. Dieses Signal wird im folgenden auch als Fehlersummensignal bezeichnet. Das Ausgangssignal s1 ist gegenüber dem Signal sO um einen Takt verzögert. Es gilt also:

$$s1 = e_n + F_{n-1} \qquad (3).$$

In dem Logikbaustein wird einerseits entschieden, ob in dem Takt n+1 ein Impuls erzeugt werden soll; andererseits wird das gespeicherte Signal sl um den Wert verringert, den das Signal p beim vorangehenden Takt n hatte; dieser Wert kann auch Null sein. Es gilt somit für das dem zweiten Eingang des Addierers 910 zugeführte Ausgangssignal s2:

$$s2 = s1 - p_n \qquad (4).$$

Wenn Gleichung (3) in Gleichung (4) eingesetzt wird, ergibt sich:

$$s2 = e_n - p_n + F_{n-1} \qquad (5).$$

Berücksicht man, daß $e_n$ und $p_n$ die Differenz bzw. das Fehlersignal für den Takt n darstellen, wird klar, daß s2 dem Fehlersummensignal für den n-ten Takt entspricht. Es gilt also:

$$s2 = F_n \qquad (6).$$

In dem Logikbaustein 912 wird in Abhängigkeit von dem Ausgangssignal s1 auch das Signal $p_{n+1}$ bestimmt. Bezeichnet man den Betrag des Maximalwertes, den das Hüllkurvensignal e annehmen kann, mit a, dann wird p = a gesetzt, wenn s1 größer ist als +a/2. Ist hingegen s1 kleiner als -a/2, dann wird p = -a gesetzt. Ist schließlich s1 nicht kleiner als -a/2 und nicht größer als +a/2, dann wird p = 0 gesetzt. Wenn der digitale Wert von a/2 sich durch eine ganzzahlige Potenz von 2 darstellen läßt, muß die Logikstufe 912 nur die höchstwertigen Bits des Signals s1 verarbeiten; die übrigen Bits können direkt zum Addierer 910 geführt werden. Dadurch wird der Aufbau er Logikstufe 912 wesentlich vereinfacht.

Entsprechend dem Verlauf des Signals p wird über die Ausgänge 93 und 94 der zweite Modulatorteil gesteuert.

Der Ausgang 93 ist mit je einem Eingang zweier Und-Gatter 922 bzw. 924 verbunden, deren anderen Eingängen der Träger c bzw. c' zugeführt wird. Ebenso ist der Ausgang 94 mit einem Eingang zweier Und-Gatter 921 bzw. 923 verbunden. Die Ausgänge der Und-Gatter 921 und 922 sind mit den Eingängen eines Oder-Gatters 925 verbunden und ebenso die Ausgänge der Und-Gatter 923, 924 mit den Eingängen eines Oder-Gatters 926. Die Ausgänge 95 und 96 der Oder-Gatter 925 und 926 bilden die (Gegentakt-) Ausgänge des Modulatorteils 92.

Die beiden Gegentaktausgangssignale der Schaltungen 925 und 926 werden der Sendestufe 8, d.h. den Steuereingängen zweier darin enthaltener Schalter 81 und 82 zugeführt, die somit im Gegentakt geöffnet bzw.

geschlossen werden. Der Verbindungspunkt der beiden Schalter, die sich mittels geeigneter Leistungs-MOS-Transistoren realisieren lassen, ist geerdet. Die von dem Verbindungspunkt abgewandten Anschlüsse der Schalter 81 und 82 sind über die Primärwicklung eines Ubertragers 83 miteinander verbunden, an dessen Sekundärwicklungen ein Signal b (t) erzeugt und der in Fig. 2 nicht näher dargestellten Hochfrequenzspule 5 (Fig. 1) zugeführt wird. Die Primärwicklung des Ubertragers 83 enthält eine Mittenanzapfung, die an eine Versorgungsspannung angeschlossen ist.

Fig. 2 zeigt einen Ausschnitt aus dem zeitlichen Verlauf der Signale, die in dem Modulator 9 bei einem Hochfrequenzimpuls erzeugt werden. In der zweiten Zeile ist der zeitliche Verlauf des Signales p(t) dargestellt, der durch ein Hüllkurvensignal hervorgerufen wird, das von einem positiven Wert aus abnimmt, den Nullpunkt durchschreitet und zunehmend negativer wird. Das Signal p enthält - im Zeitintervall t1-t3 - zunächst zwei aufeinanderfolgende Impulse mit positiver Polarität. Da der kürzeste Abstand zwischen zwei Impulsen, d.h. zwischen ihren Vorderflanken und zwischen ihren Rückflanken T ist (T ist die Periodendauer einer Schwingung des Trägers c bzw. c') und da die Dauer jedes Impulses ebenfalls T ist, gehen die beiden Impulse lückenlos ineinander über.

Bei einem positiven Impuls (p = + a) ist das Signal am Ausgang 93 logisch "0" und am Ausgang 94 logisch "1". Infolgedessen gelangt das Signal c (dritte Zeile), das während der ersten Hälfte eines Impulses "1" ist, über das Und-Gatter 921, das Oder-Gatter 925 und den Ausgang 95 zum Schalter 81, solange p positiv (= "1") ist. Ebenso gelangt das Signal c' (4. Zeile) in der zweiten Hälfte eines Impulses zum Schalter 82. Somit wird 81 während der ersten Hälfte und 82 während der zweiten Hälfte eines positiven Impulses geöffnet. Dies wiederholt sich in den Zeitintervallen t4 - t5 und t7 - t8.

In den Intervallen t3 - t4 und t6 - t7 wird kein Impuls erzeugt (p = 0), und die Signale an den Ausgängen 93 und 94 sind "0". Somit sind in diesen Intervallen alle Und-Gatter gesperrt, und die Sendestufe erhält kein Eingangssignal.

Im Intervall t7 - t8 folgt auf einen positiven Impuls unmittelbar ein negativer Impuls (p = - a). Während dieses Impulses und während aller anderen negativen Impulse ist das Signal am Ausgang 93 "1" und am Ausgang 94 "0". Daher gelangt das Signal c an den Ausgang 96 und das Signal c' an den Ausgang 95, solange p negativ ist. Bei einem negativen Impuls wird also - anders als bei einem positiven Impuls - zuerst der Schalter 83 und dann der Schalter 81 geöffnet.

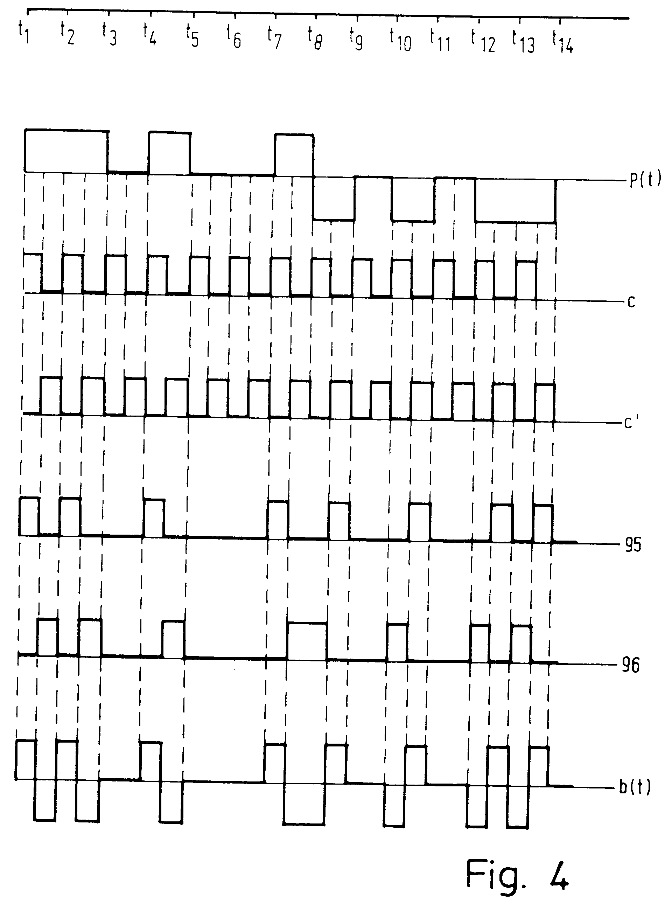

Der sich bei diesem Verlauf von p (zweite Zeile) ergebende zeitliche Verlauf der Signale an den Ausgängen 95 und 96 ist in den Zeilen 5 und 6 von Fig. 4 dargestellt. Das daraus resultierende Signal b an der Sekundärwicklung des Ubertragers 83) ist in der siebten Zeile dargestellt (idealisiert - weil der tatsächliche Verlauf nicht exakt rechteckförmig ist). Man erkennt, daß bei einem positiven Impuls genau eine Trägerschwingung mit einer ersten Phasenlage und bei einem negativen Impuls eine Trägerschwingung mit einer demgegenüber um 180° versetzten Phasenlage erzeugt wird, und daß in den Impulspausen keine Trägerschwingungen erzeugt werden. Zur Zeit $t_8$, zu der der positive Impuls in einen negativen Impuls übergeht, springt die Phase um 180°.

Das Signal an der Sekundärwicklung des Ubertragers 83 enthält neben Komponenten mit der Larmorfrequenz auch höherfrequente Störkomponenten, die durch höhere Harmonische des Trägersignals bzw. dadurch hervorgerufen werden, daß die Trägerschwingungen in den Impulspausen ganz unterdrückt werden. Diese Störkomponenten sind für die Kernspinuntersuchung an sich nicht unmittelbar störend. Sie können jedoch von der auf die Lamorfrequenz abgestimmten Hochfrequenzspule reflektiert werden und die Sendestufe zerstören. Es ist daher zweckmäßig, diese Komponenten durch ein Filter zu beseitigen, das beispielsweise durch den geeignet dimensionierten Ubertrager 83 - ggf. in Verbindung mit einem der Primärwicklung dieses ubertragers parallelgeschalteten Kondensator - gebildet werden kann.

Die Hochfrequenzleistung, die der Hochfrequenzspule über die Sendestufe 8 zugeführt wird, hängt - da diese im Schalterbetrieb betrieben wird - quadratisch von der Versorgungsspannung U ab. Netzspannungsschwankungen oder andere Einflüsse, die sich in einer Veränderung der Versorgungsspannung auswirken, können daher die durchgeführten Kernspinuntersuchungen negativ beeinflussen. Das gleiche gilt auch für die der Versorgungsspannung überlagerte Restwelligkeit ("ripple"). Diese störenden Einflüsse könnten durch Verwendung eines stabilisierten Netzteils beseitigt oder zumindest doch vermindert werden. Derartige Netzteile müßten jedoch für sehr hohe Leistungen (einige hundert W bzw. einige kW) ausgelegt sein und wären entsprechend teuer.

Fig. 5 zeigt das Blockschaltbild einer weniger aufwendigen Lösung dieses Problems. Die unstabilisierte und somit Netzspannungsschwankungen ausgesetzte sowie mit einer Restwelligkeit behaftete Versorgungsspannung U wird über einen Meßspannungsteiler 12 einem Analog/Digital-Wandler 13 zugeführt. Dieser ist an eine stabilisierte Versorgungsspannung $U_S$ angeschlossen. Dafür muß zwar auch ein stabilisierter Versorgungsspannungserzeuger vorhanden sein, doch muß dieser nur fur niedrige Leistungen ausgelegt sein. Das Ausgangssignal des Analog/Digital-Wandlers repräsentiert somit den Momentanwert der unstabilisierten Versorgungsspanung U. Dieses digitale Ausgangssignal wird einer Schaltung 14 zugeführt. Die Schaltung 14 kann einen Tabellenspeicher enthalten, in dem jedem Eingangssignal ein dazu näherungsweise proportionales Ausgangssignal zugeführt und in ein digitales Ausgangssignal umgesetzt wird, das zumindest annähernd dem Reziprokwert des Eingangssignal proportional ist. Dieses Signal ist somit 1/U proportional. Es wird dem einen Eingang eines digitalen Multiplizierers zugeführt, dessen anderem Eingang das Hüllkurvensignal e zugeführt wird. Am Ausgang des Multiplizierers ergibt sich somit ein digitales Signal e', das der Versorgungsspannung U proportional ist.

Vergrößert die Versorgungsspannung U sich beispielsweise, dann ist e' entsprechend kleiner als e, so daß trotz höheren Energieinhalts einer einzelnen, der Hochfrequenzspule zugeführten Schwingung die Hochfrequenzleistung wegen der verringerten Impulsdichte konstant bleibt. Da wegen der unvermeidlichen Spannungsabfälle an den Schaltern 81, 82 die Amplitude am Ausgang der Sendestufe nicht exakt proportional ist zur Versorgungsspannung, darf das Ausgangssignal der Schaltung 14 zum Signal des Analog/Digital-Wandlers 13 nur näherungsweise umgekehrt proportional sein.

Es ist aber auch möglich, daß stattdessen das andere Eingangssignal - s2 - in Abhängigkeit von dem Ausgangssignal des Analog/Digital-Wandlers 13 modifiziert wird, das gemäß Gleichung (6) dem Fehlersummensignal F entspricht. Zu diesem Zweck müßte das Signal F lediglich mit einem Faktor multipliziert werden, der annähernd proportional ist zum Ausgangsignal des Analog/Digital-Wandlers 13.

Vorstehend wurde die Erfindung anhand eines Ausführungsbeispiels erläutert, bei dem im Impulsdichtemodulator Impulse erzeugt werden , die zwei verschiedene Digitalwerte annehmen können, und davon abhängig der Träger in zwei um 180° gegeneinander versetzten Phasenlagen ein- und ausgeschaltet wird. Es ist jedoch auch möglich, Impulse zu erzeugen, die k verschiedene Digitalwerte annehmen können (wobei k größer ist als 2) und davon abhängig, bei jedem Impuls eine Trägerschwingung zu erzeugen, deren Phasenlage sich von der Phasenlage bei den anderen möglichen Werten eines Impulses um 360°/k oder ein ganzzahliges Vielfaches davon unterscheidet. Zwar wächst dann der Schaltungsaufwand für den Modulator 9, aber es könnten dann (bei k = 4) auch komplexe Hüllkurvensignale, d.h. Signale mit einem Real- und einem Imaginärteil, verarbeitet werden, was zur Erzeugung von Einseitenband-Signalen oder zur Speisung von Quadraturspulen von Nutzen sein. Die realen und die imaginären Komponenten könnten dann getrennt in einem Modulator wie dem Modulator 9 verarbeitet werden, wobei dem einen Modulator der Realteil und dem anderen der Imaginärteil des Hüllkurvensignals zugeführt werden müßte und wobei die dem zweiten Modulator zugeführten Trägersignale gegenüber den dem ersten Modulator zugeführten Signalen um 90° in der Phase versetzt sein müßten. Die Ausgangssignale der Modulatoren müßten dann ggf. noch in geeigneter Weise miteinander kombiniert werden.

**Patentansprüche**

1. Hochfrequenzerzeuger für Kernspinuntersuchungsgeräte, mit einem Modulator, in dem ein Träger mit einem Hüllkurvensignal moduliert wird und mit einer dem Modulator nachgeschalteten Sendestufe, <u>dadurch gekennzeichnet</u>, daß der Modulator (9) einen ersten Modulatorteil (91) enthält, in dem das Hüllkurvensignal (e) in eine Folge mehrerer gleich langer digitaler Impulse (p) umgesetzt wird, deren Wert durch das Hüllkurvensignal bestimmt wird und deren Dichte der Amplitude des Hüllkurvensignals entspricht, und daß der erste Modulatorteil (92) einen zweiten Modulatorteil so steuert, daß die im Schaltbetrieb arbeitende Sendestufe (8) nur während der Dauer der Impulse Trägerschwingungen liefert, wobei die Phase der Trägerschwingungen durch den Wert der Impulse bestimmt ist.

2. Hochfrequenzerzeuger nach Anspruch 1, wobei die Impulse drei verschiedene Werte haben, von denen einer der positiven Polarität und ein anderer der negativen Polarität des Hüllkurvensignals zugeordnet ist, daß die Trägerschwingungen mit einer ersten Phasenlage (c) und einer zweiten, gegenüber der ersten um 180° versetzten Phasenlage (c') erzeugt werden, daß die Sendestufe bei Impulsen mit dem einen Wert die Trägerschwingung mit der ersten Phasenlage und bei Impulsen mit dem anderen Wert die Trägerschwingung mit der entgegengesetzten Phasenlage erzeugt, und daß bei Impulsen mit dem dritten Wert keine Trägerschwingung erzeugt wird.

3. Hochfrequenzerzeuger nach einem der vorhergehdenden Ansprüche, wobei der Träger während eines Impulses gerade eine oder mehrere ganze Schwingungen ausführt, und daß der Abstand zwischen zwei aufeinanderfolgenden Impulsen mT ist, wobei m eine positive ganze Zahl und T die Periodendauer einer Träger schwingung ist.

4. Hochfrequenzerzeuger nach einem der vorhergehenden Ansprüche, wobei die Sendestufe eine Gegentaktschaltstufe (81, 82) umfaßt.

5. Hochfrequenzerzeuger nach einem der vorhergehenden Ansprüche mit einem am Ausgang der Sendestufe angeordneten Filter (83) zur Verringerung der höheren Harmonischen der Trägerfrequenz.

6. Hochfrequenzerzeuger nach Anspruch 5, wobei die Sendestufe einen Ausgangsübertrager (83) aufweist, der so bemessen ist, daß er die höheren Harmonischen der Trägerfrequenz wenigstens teilweise unterdrückt.

7. Hochfrequenzerzeuger nach einem der vorhergehenden Ansprüche, wobei
die Sendestufe an eine nicht stabilisierte Versorgungsspannung (U) angeschlossen ist, daß ein Analog/Digital-Wandler vorgesehen ist, der ein der Versorgungsspannung proportionales Signal digitalisiert, und daß die Impulsdichte in Abhängigkeit vom Ausgangssignal des Analog/Digital-Wandlers derart gesteuert wird, daß die Impulsdichte sich gegensinnig zur Versorgungsspannung ändert.

8. Hochfrequenzerzeuger nach einem der vorhergehenden Ansprüche, wobei
der erste Modulatorteil einer Akkumulatorschaltung zur Bildung eines von dem Integral der Differenz (F) zwischen den Impulsen und dem Hüllkurvensignal abhängigen Steuersignals (51) vorgesehen ist, und daß das Steuersignal eine Logikschaltung (912) beaufschlagt, die einen Impuls mit positiver oder negativer Polarität erzeugt derart, daß das Integral innerhalb eines bestimmten Bereiches bleibt.

## Claims

1. An rf generator for magnetic resonance examination apparatus, comprising a modulator in which a carrier is modulated with an envelope signal, and also comprising a transmitter stage which is connected subsequent to the modulator, <u>characterized in that</u> the modulator (9) comprises a first modulator section (91) in which the envelope signal (e) is converted into a series of equally long digital pulses (p) whose value is determined by the envelope signal and whose density corresponds to the amplitude of the envelope signal, and that the first modulator section controls a second modulator section (92) so that the transmitter stage (8) operating in the switching mode supplies carrier oscillations only during the pulses, the phase of the carrier oscillations being determined by the value of the pulses.

2. An rf generator as claimed in Claim 1, in which the pulses have three different values, one of which is assigned to the positive polarity whilst another is assigned to the negative polarity of the envelope signal, the carrier oscillations being generated with a first phase position (c) and a second phase position (c') which has been shifted through 180° with respect to the first phase position, the transmitter stage producing the carrier oscillation having the first phase position for pulses of one value the carrier oscillation having the opposite phase position in the case of pulses having the other value, no carrier oscillation being generated in the case of pulses having the third value.

3. An rf generator as claimed in any one of the preceding Claims, in which during a pulse the carrier performs exactly one or more complete oscillations, the spacing between two successive pulses amounting to mT, where m is a positive integer and T is the period duration of an oscillation.

4. An rf generator as claimed in any one of the preceding Claims, in which the transmitter stage comprises a pushpull switching stage (81, 82).

5. An rf generator as claimed in any one of the preceding Claims, comprising a filter (83) which is connected to the output of the transmitter stage in order to reduce the higher harmonics of the carrier frequency.

6. An rf generator as claimed in Claim 5, in which the transmitter stage comprises an output transformer (83) which is proportioned so that it at least partly suppresses the higher harmonics of the carrier frequency.

7. An rf generator as claimed in any one of the preceding Claims in which the transmitter stage is connected to a non-stabilized supply voltage (U), there being provided an analog-to-digital converter which digitizes a signal which is proportional to the supply voltage, the pulse density being controlled in dependence on the output signal of the analog-to-digital converter insuch a manner that the pulse density varies in the opposite sense with respect to the supply voltage.

8. An rf generator as claimed in any one of the preceding Claims, in which the first modulator section comprises an accumulator circuit for forming a control signal (51) which depends on the integral of the difference (F) between the pulses and the envelope signal, the control signal being applied to a logic circuit (912) which generates a pulse having a positive or a negative polarity so that the integral remain within a given range.

## Revendications

1. Générateur de haute fréquence pour un appareil d'examen à spin nucléaire, comprenant un modulateur, dans lequel une porteuse est modulée par un signal d'enveloppe, et un étage émetteur connecté en aval au modulateur, caractérisé en ce que le modulateur (9) contient une première partie de modulateur (91) dans laquelle le signal d'enveloppe (e) est converti en une succession de plusieurs impulsions numériques (p) de même longueur, dont la valeur est déterminée par le signal d'enveloppe et dont la densité correspond à l'amplitude du signal d'enveloppe, et que la première partie de modulateur (91) commande une deuxième partie de modulateur, de telle façon que l'étage émetteur (8) fonctionnant en mode de commutation ne délivre des oscillations de porteuse que pendant la durée des impulsions, tandis que la phase des oscillations de porteuse est déterminée par la valeur des impulsions.

2. Générateur de haute fréquence suivant la revendication 1, dans lequel les impulsions ont trois valeurs différentes, dont l'une est affectée à la polarité positive et une autre à la polarité négative du signal d'enveloppe, les oscillations de porteuse sont produites avec une première relation de phase (c) et une deuxième relation de phase (c') décalée de 180° de la première, l'étage émetteur produit, lors d'impulsions de la première valeur, l'oscillation de porteuse présentant la première relation de phase et, lors d'impulsions de l'autre valeur, l'oscillation de porteuse présentant la relation de phase opposée et, lors d'impulsions de la troisième valeur, aucune oscillation de porteuse n'est produite.

3. Générateur de haute fréquence suivant l'une quelconque des revendications précédentes, dans lequel la porteuse exécute exactement une ou plusieurs oscillations complètes pendant une impulsion et la distance entre deux impulsions successives est mT, où m est un nombre entier positif et T est la durée de la période d'une oscillation de porteuse.

4. Générateur de haute fréquence suivant l'une quelconque des revendications précédentes, dans lequel l'étage émetteur comprend un étage de commutation symétrique (81, 82).

5. Générateur de haute fréquence suivant l'une quelconque des revendications précédentes, comprenant un filtre (83) monté à la sortie de l'étage émetteur pour l'atténuation des harmoniques supérieurs de la fréquence porteuse.

6. Générateur de haute fréquence suivant la revendication 5, dans lequel l'étage émetteur comprend un transformateur de sortie (83) qui est dimensionné de telle façon qu'il supprime au moins partiellement les harmoniques supérieurs de la fréquence porteuse.

7. Générateur de haute fréquence suivant l'une quelconque des revendications précédentes, dans lequel l'étage émetteur est connecté à une tension d'alimentation non stabilisée (U), un convertisseur analogique/numérique est prévu, qui numérise un signal proportionnel à la tension d'alimentation et la densité d'impulsions est commandée en fonction du signal de sortie du convertisseur analogique/numérique, de telle façon que la densité d'impulsions se modifie en sens contraire de la tension d'alimentation.

8. Générateur de haute fréquence suivant l'une quelconque des revendications précédentes, dans lequel la première partie de modulateur est pourvue d'un circuit accumulateur pour la formation d'un signal de commande (51) dépendant de l'intégrale de la différence (F) entre les impulsions et le signal d'enveloppe, et le signal de commande attaque un circuit logique (912) qui produit une impulsion de polarité positive ou négative de façon que l'intégrale reste à l'intérieur d'un domaine défini.

## Fig.1

## Fig.5

Fig. 2

e

Fig.3a

Fig.3b

Fig. 4